Europäisches Patentamt

European Patent Office

Office européen des brevets

(19)

(11) Publication number:

**0 307 246**
A2

## (12) EUROPEAN PATENT APPLICATION

(21) Application number: 88308384.2

(22) Date of filing: 07.09.88

(51) Int. Cl.⁴: **H 01 L 39/24**

(30) Priority: 07.09.87 JP 223675/87
16.09.87 JP 231888/87

(43) Date of publication of application:
15.03.89 Bulletin 89/11

(84) Designated Contracting States: DE FR GB

(71) Applicant: SEMICONDUCTOR ENERGY LABORATORY
CO., LTD.
398 Hase
Atsugi-shi Kanagawa-ken, 243 (JP)

(72) Inventor: Yamazaki, Shunpei
21-21 Kitakarasuyama 7-chome
Setagaya-ku Tokyo (JP)

(74) Representative: Milhench, Howard Leslie et al
R.G.C. Jenkins & Co. 26 Caxton Street
London SW1H 0RJ (GB)

(54) Method of manufacturing superconducting devices.

(57) A method of manufacturing Josephson devices is described. A superconducting ceramics film is deposited on a non-conductive surface and partly spoiled in order to form a barrier film by means of which two superconducting regions are separated. The spoiling is performed by adding a spoiling element into the ceramics film by ion implantation.

EP 0 307 246 A2

## Description

## Method of Manufacturing Superconducting Devices

### BACKGROUND OF THE INVENTION

This invention relates to a method of manufacturing superconducting devices.

Efforts are continuously being made to achieve more densely packed integrated circuits and to obtain higher operational speeds. The fine structures of densely packed electric circuits can give rise to problems of decreased operational speed and problems of unreliability can arise at exothermic parts of integrated circuits. Because of this, if semiconductor devices are operated at cryogenic temperatures such as the boiling point of liquid nitrogen for example, electron and hole mobilities can become 3 to 4 times faster than room temperature mobilities and as a result the frequency characteristics of the devices can be improved.

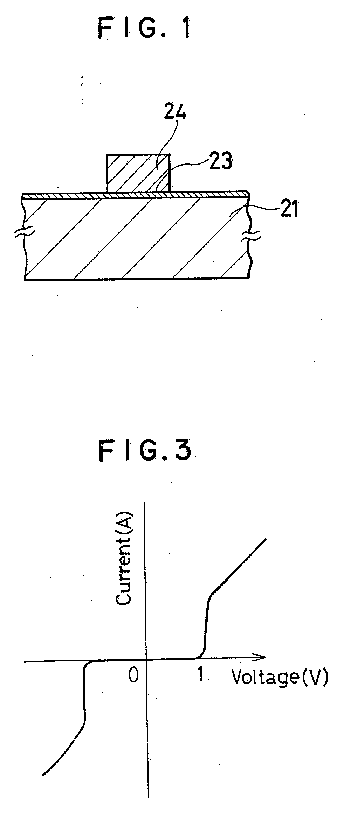

Josephson devices, such as for example a memory which functions on the basis of the Josephson effect, are known examples of superconductive electronic devices. In such devices, switching operations associated with the Josephson effect can be performed. A schematic illustration of an example of such a device is shown in Fig.1 of the accompanying drawings, the device comprising a superconducting film 24 adjacent a superconducting region formed within a substrate 21 with a barrier film 23 provided therebetween. The principal advantage of the device resides in its operability at very high frequency. However, the proportion of oxygen contained in superconducting ceramics of this type tend to be reduced.

### OBJECTS AND SUMMARY OF THE INVENTION

It is therefore an object of the present invention to provide a method of effectively manufacturing superconducting devices.

It is another object of the present invention to provide a method of manufacturing superconducting devices which provides high production yield.

In order to accomplish the above and other objects and advantages, the present invention provides for non-superconducting regions to be formed within ceramics superconductors by adding thereto an element which functions to spoil the superconducting structure of the ceramics and render the same electrically insulative. The non-superconducting region is thermal annealed or fired. When a superconducting film is formed on a surface, the (a,b) plane in the crystalline film is preferably aligned parallel to the underlying surface because current can flow along that plane with a current density 100 times that along the normal direction thereto.

Preferred examples of the elements to be added to superconducting ceramics for the purpose of converting the superconducting structure to an insulating non-superconducting structure are Si, Ge, B, Ga, P, Ta, Mg, Be, Al, Fe, Co, Ni, Cr, Ti, Mn and Zr.

Preferred examples of the superconducting ceramics materials used in accordance with the present invention are those represented by the stoichiometric formula $(A_{1-x}B_x)_yCu_zO_w$ where A is one or more elements of Group IIIa of the Japanese Periodic Table, e.g. the rare earth elements or lanthanides, B is one or more alkaline earth metals, i.e. Ba, Sr and Ca, and $0 < x < 1$; $y = 2.0 - 4.0$, preferably $2.5 - 3.5$; $z = 1.0 - 4.0$, preferably $1.5 - 3.5$; and $w = 4.0 - 10.0$, preferably $6.0 - 8.0$. When superconducting ceramics of this type are employed, the spoiled non-superconducting ceramics regions that are obtained in accordance with the invention are represented by the stoichiometric formula $[(A'_pA''_{1-p})_{1-x}(B'_qB''_{1-q})_x]_y(Cu_rX_{1-r})_zO_w$ where A' is one or more elements of Group IIIa of the Japanese Periodic Table, e.g. the rare earth elements or lanthanides, B' is one or more alkaline earth metals, i.e. Ba, Sr and Ca, A'', B'' and X are selected from the group consisting of Mg, Be, Al, Fe, Co, Ni, Cr, Ti, Mn and Zr, and $x = 0.1 - 1$; $y = 2.0 - 4.0$, preferably $2.5 - 3.5$; $2 = 1.0 - 4.0$, preferably $1.5 - 3.5$; and $W = 4.0 - 10.0$, preferably $6.0 - 8.0$. The numbers p, q and r may be chosen to be 0.99 to 0.80 so that the total proportion of A'', B'' and X is 1-25 atom% in the ceramic material. In the particular case of Mg and Al, this proportion may be 1-10 atom%, e.g. 5-10 atom%. The total density of the spoiling elements in the resultant non-superconducting ceramic may be about $5 \times 10^{18}$ to $6 \times 10^{21} cm^{-3}$. Since the superconducting properties of superconducting ceramics are sensitive to the relative proportions of their constituents, the spoiling element can be selected from among the constituents of the superconducting ceramics themselves. When superconducting constituents are employed as the spoiling element, the total density of the additional elements may be $5 \times 10^{19}$ to $5 \times 10^{22} cm^{-3}$.

Further features of the present invention are set forth with particularity in the appended claims and all such features, together with advantages thereof, will become clear from consideration of the following description of exemplary embodiments which are illustrated in the accompanying drawings.

### BRIEF DESCRIPTION OF THE DRAWINGS

Fig.1 is a schematic view showing a prior art superconducting device;

Figs.2(A) to 2(C) are cross-sectional views showing first, second and third embodiments of the present invention;

Fig.3 is a graphical diagram showing the current-voltage characteristic of devices in accordance with the present invention; and

Figs.4(A) to 4(C) are cross-sectional views showing fourth, fifth and sixth embodiments of the present invention.

## DETAILED DESCRIPTION OF THE EMBODIMENTS

For the avoidance of doubt it is to be noted that all references herein to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIa and VIIa of the Japanese Periodic Table correspond respectively to Groups IIIb, IVb, Vb, VIb and VIIb of the European Periodic Table; and Groups IIIb, IVb, Vb, VIb and VIIb of the Japanese Periodic Table correspond respectively to Groups IIIa, IVa, Va, VIa and VIIa of the European Periodic Table.

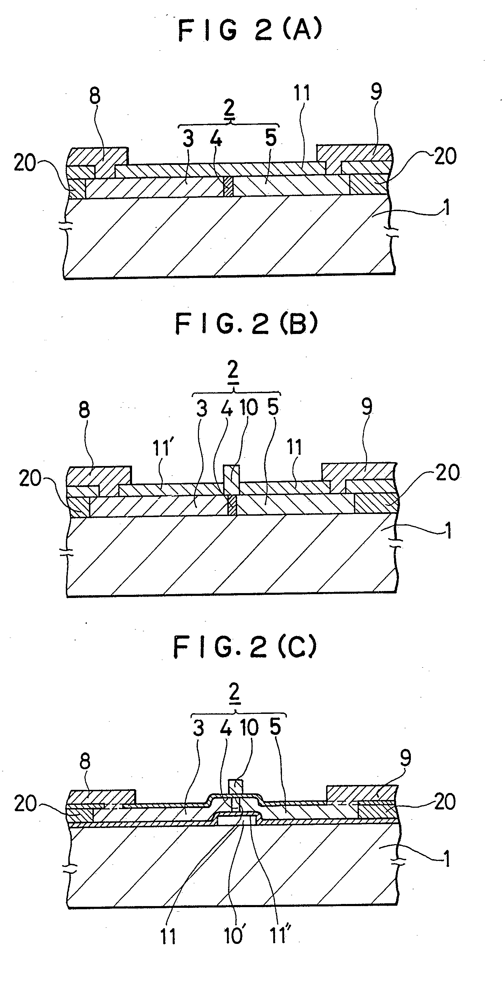

Referring now to Figs.2(A) to 2(C), exemplary superconducting devices in accordance with the present invention are illustrated therein and will be described in the following.

The device shown in Fig.2(A) comprises a substrate 1 having a non-conductive upper surface, such as a substrate of YSZ(yttria stabilized zircon) for example, a pair of superconducting regions 3 and 5, and intervening barrier film 4 between the regions 3 and 5, insulating films 20 positioned at the opposed ends of the superconducting regions 3 and 5, an overlying passivation film 11 formed with openings 11-1 and 11-2 communicating with the regions 3 and 5, and electrodes 8 and 9 electrically contacting the superconducting regions 3 and 5.

An exemplary method of manufacturing the device of Fig.2(A) will now be described. First, a ceramic oxide film of a composition in accordance with the composition of a superconducting material as specifically recited hereinbefore is formed on the substrate 1 by screen printing, sputtering, MBE (Molecular Beam Epitaxy), CVD or any other known method. At the same time, or thereafter, the ceramic oxide is thermally annealed at 600-950°C for 5-20 hours followed by gradual cooling. In accordance with experimental results obtained, the critical temperature of the superconductor obtained was measured to be 91K for example.

The barrier film 4 is formed after or before the annealing stage by adding a spoiling element such as aluminium or magnesium to the corresponding region of the superconductor by ion implantation for example to a concentration of $5 \times 10^8 - 6 \times 10^{21} \mathrm{cm}^{-3}$, e.g., $2 \times 10^{20} \mathrm{cm}^{-3}$. The ion implantation may for example be performed at an acceleration voltage of 50-2000 V with a photoresist mask covering the superconducting regions 3 and 5 so that the barrier film 4 and the insulating films 20 become non-superconducting. The barrier film 4 is formed to be no wider than 1000Å in the lateral direction in order to permit tunnel currents to flow therethrough.

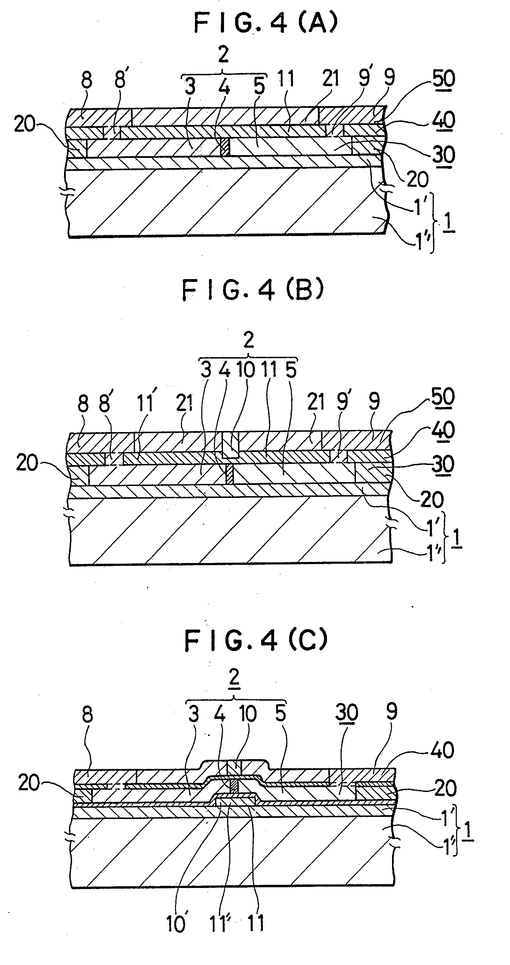

The passivation film 11 comprises an insulating ceramics having a similar composition to the underlying superconducting ceramics film and is formed over the structure, followed by oxidation in an oxidizing atmosphere at 300-950°C, e.g. 700°C, for the purpose of fitting the films of the structure together and compensating the oxygen proportion at the surface area. The passivation film 11 may be spoiled so as to be non-superconducting in the same manner as described above, or may be formed at the outset in accordance with the composition of a spoiled superconductor. The spoiling element is oxidized during this oxidation process. Then, after forming the openings 11-1 and 11-2, the lead electrodes 8 and 9 are formed so as to be in ohmic contact with the superconducting regions 3 and 5 respectively. The electrodes 8 and 9 may themselves be formed of superconducting ceramics, in which case the formation of the electrodes is preferably carried out before the annealing stage. Fig.3 is an example of the voltage-current characteristic obtained with devices in accordance with the present invention.

In the above described example, the densities of the spoiling element in the barrier film 4 and in the insulating films 20 are the same. However, by separately effecting ion implantation, the films 4 and 20 can be formed so that the spoiling element density of the barrier film 4 is 0.1 to 20 atom% which is 1/10 - 1/5, e.g. 1/5, of the spoiling element density of the insulating films 20.

Referring to Fig.2(B), a second embodiment of the present invention is illustrated. This embodiment is approximately the same as the previous embodiment except for the provision of a control electrode 10 formed over the barrier film 4 with the insulating film 11 therebetween. The current passing through the barrier film 4 can thus be controlled by controlling the voltage applied to the control electrode 10. In this embodiment, the barrier film 4 may be superconducting. In that case, the operating temperature of the device should be selected so that the superconducting barrier film 4 is in an intermediate state between superconductivity and non-superconductivity. Namely, the operating temperature is selected to be within the range between Tc onset and Tco. The action of the device is described in our US patent application Serial No. 167,987 filed on 14th/03/88.

Referring to Fig.2(C), a third embodiment is illustrated. This device is approximately the same as the second embodiment except for the provision of an underlying control electrode 10'. The barrier film 4 is sandwiched between the overlying control film 10 and the underlying control film 10'. The layers shown between the substrate 1 and the superconductor portions 3 and 5, and between the superconductor portions 3 and 5 and the electrode portions 8,9 and 10 are insulating oxide films analogous to the gate insulating films of FET's.

Figs.4(A) to 4(C) are modifications of the preceding embodiments shown in Figs.2(A) to 2(C) respectively. These embodiments are constructed in substantially the same manner as the preceding embodiments with the exceptions specified below.

Fig.4(A) is a cross-sectional view showing a fourth embodiment of the present invention. The substrate 1″ is a portion of a silicon semiconductor substrate within which an integrated circuit is formed. The upper surface of the substrate 1″ is made non-conductive by covering it with a ceramic oxide film 1′. After forming the superconducting regions 3 and 5, the barrier film 4 and the insulating films 20 on the substrate in the same manner as described in the foregoing, a superconducting ceramic oxide film 40 is formed and is made non-superconducting by adding a spoiling element thereto except in the region of the connection portions 8′ and 9′. Then a superconducting ceramic film 50 is formed on the structure, followed by spoiling of the superconducting structure except in the regions constituting the electrodes 8 and 9. Although the fabrication process of this embodiment substantially corresponds to that of the preceding embodiments, the electrodes 8 and/or 9 which may be connected with the integrated circuit within the substrate must not be subjected to thermal treatment at above 400°C in order to avoid oxidation of the silicon semiconductor by the oxygen content of the superconducting electrodes 8 and 9.

Referring to Fig.4(B), a fifth embodiment of the present invention is illustrated. This embodiment is approximately the same as the fourth embodiment except for the provision of a control electrode 10 made of a superconducting ceramic formed over the barrier film 4 with the insulating film 11 therebetween. The tunnel current passing through the barrier film 4 may be controlled by controlling the voltage applied to the control electrode 10. In this embodiment, the barrier film 4 may be superconducting in which case the operating temperature of the device should be selected so that the superconducting barrier film 4 is in an intermediate state between superconductivity and non-superconductivity. Namely, the operating temperature should be selected within the range between Tc onset and Tco.

Referring to Fig.4(C), a sixth embodiment is illustrated. This device is approximately the same as the fifth embodiment except for the provision of an underlying control electrode 10′. The barrier film 4 is sandwiched between the overlying control film 10 and the underlying control film 10′.

Superconducting ceramics for use in accordance with the present invention also may be prepared to be consistent with the stoichiometric formulae $(A_{1-x}B_x)_yCu_zO_w$ where A is one or more elements of Group IIIa of the Japanese Periodic Table, e.g. the rare earth elements, B is one or more elements of Group IIa of the Japanese Periodic Table, e.g. the alkaline earth metals including beryllium and magnesium, and $0<x<1$; $y = 2.0 - 4.0$, preferably $2.5 - 3.5$; $z = 1.0 - 4.0$, preferably $1.5 - 3.5$; and $w = 4.0 - 10.0$, preferably $6.0 - 8.0$. Also, superconducting ceramics for use in accordance with the present invention may be prepared to be consistent with the stoichiometric formulae $(A_{1-x}B_x)_yCu_zO_w$ where A is one or more elements of Group Vb of the Japanese Periodic Table such as Bi, Sb and As, B is one or more elements of Group IIa of the Japanese Periodic Table, e.g. the alkaline earth metals including beryllium and magnesium, and $x = 0.3 - 1$; $y = 2.0 - 4.0$, preferably $2.5 - 3.5$; $z = 1.0 - 4.0$, preferably $1.5 - 3.5$; and $w = 4.0 - 10.0$, preferably

$6.0 - 8.0$. Examples of this general formula are $BiSrCaCuCu_2O_x$ and $B_14Sr_3Ca_3Cu_4O_x$. Tc onset and Tco of samples confirmed to be consistent with the formula $Bi_4Sr_yCa_3Cu_4O_x$ (y is around 1.5) were measured to be 40-60°K, which is not so high. Relatively high critical temperatures were obtained with samples conforming to the stoichiometric formulae $Bi_4Sr_4Ca_2Cu_4O_x$ and $Bi_2Sr_3Ca_2Cu_2O_x$ where the number x denoting the oxygen proportion is 6-10, e.g. around 8.1. Such superconducting materials can be formed by screen press printing, vacuum evaporation or CVD for example.

While several embodiments of the invention have been described, it is to be understood that the present invention is not limited to the particular examples described and many modifications and variations will occur to those possessed of the relevant skills without departure from the spirit and scope of the invention. For example, the present invention can be applied to SQUIDS, VLSIs or ULSIs. The superconducting ceramics in accordance with the present invention may have single crystalline or polycrystalline structures.

**Claims**

1. A method of producing a superconducting device comprising:
forming upon a non-conductive surface a ceramics film of a composition capable of exhibiting superconductivity; and
establishing in said ceramics film a superconducting structure having its C plane parallel to said surface by application of thermal treatment to said film; and
wherein a spoiling element is introduced into a selected region of said ceramic film in order to change the composition thereof to a composition which does not support superconductivity.

2. The method of claim 1 wherein the selected region into which the spoiling element is introduced is such as to define in the superconducting device spaced apart superconducting regions separated by a barrier film of non-superconducting material.

3. The method of claim 2 wherein the thickness of said barrier film is such that tunnel currents can flow therethrough.

4. The method of any preceding claim wherein the introduction of said spoiling element is performed by ion implantation.

5. The method of any preceding claim wherein said surface is the surface of a YSZ substrate.

6. The method of any of claims 1 to 4 wherein said surface is formed by coating a silicon semiconductor substrate with an insulating ceramic oxide film.

7. The method of claim 3 or any of claims 4, 5 and 6 as dependent upon claim 3 wherein the upper surface of said ceramic film is covered by an insulating oxide film.

8. The method of claim 7 wherein an upper superconducting pattern is formed on said insulating ceramic oxide film.

9. The method of claim 8 wherein said upper superconducting pattern is formed so as to be in contact with said spaced-apart superconducting regions.

10. The method of claim 9 wherein said upper superconducting pattern defines two lead electrodes each contacting a respective one of said spaced apart superconducting regions.

11. The method of claim 10 wherein said upper superconducting pattern further defines a control electrode located above said barrier film with said insulating film therebetween.

12. The method of claim 10 or 11 wherein said lead electrodes and/or said control electrode is fabricated by forming a superconducting film and spoiling all but the portion(s) thereof which define said lead electrodes and/or control electrodes.

13. The method of any preceding claim wherein said composition capable of exhibiting superconductivity is consistent with the stoichiometric formula $(A_{1-x}B_x)_yCu_2O_w$ where A is one or more elements of Group IIIa of the Japanese Periodic Table, e.g. the rare earth elements or lanthanides, B is one or more alkaline earth metals, i.e. Ba, Sr and Ca, and $0 <$ $x < 1$; $y = 2.0 - 4.0$, $z = 1.0 - 4.0$ and $W = 4.0 - 10.0$.

14. The method of claim 13 wherein said spoiling element is selected from the group comprising Si, Ge, B, Ga, P, Ta, Mg, Al, Fe, Co, Ni, Cr, Ti, Mn and Zr.

15. The method of claim 14 wherein the composition of said spoiled ceramic film conforms to the stoichiometric formula $[(A'_pA''_{1-p})_{1-x}(B'_qB''_{1-q})_x]_y(Cu_rX_{1-r})_zO_w$ where A' is one or more elements of Group IIIa of the Japanese Periodic Table, e.g. the rare earth elements or lanthanides, B' is one or more alkaline earth metals, i.e. Ba, Sr and Ca, A'', B'' and X are at least one of said spoiling elements, and $x = 0.1 - 1$; $y = 2.0 - 4.0$, $2.5 - 3.5$; $z = 1.0 - 4.0$, and $w = 4.0 - 10.0$.

16 A method of manufacturing a superconducting device in accordance with which one or more non-superconducting or less-superconductive regions are defined in a superconducting ceramics material by introduction of a spoiling agent into the ceramics material at said one or more regions.

17. A superconducting device manufactured by a method according to any of the preceding claims.

# F I G. 1

# F I G. 3

# FIG 2 (A)

# FIG. 2 (B)

# FIG. 2 (C)

EP 0 307 246 A2

# F I G. 4 (A)

# F I G. 4 (B)

# F I G. 4 (C)